(19) Europäisches Patentamt
European Patent Office
Office européen des brevets

(11) **EP 2 697 461 B1**

(12) **EUROPÄISCHE PATENTSCHRIFT**

(45) Veröffentlichungstag und Bekanntmachung des Hinweises auf die Patenterteilung:
**10.05.2017** **Patentblatt 2017/19**

(21) Anmeldenummer: **12721713.1**

(22) Anmeldetag: **24.03.2012**

(51) Int Cl.:
**E05B 85/02** *(2014.01)* **E05B 81/54** *(2014.01)*

(86) Internationale Anmeldenummer:
**PCT/DE2012/000318**

(87) Internationale Veröffentlichungsnummer:
**WO 2012/139545 (18.10.2012 Gazette 2012/42)**

(54) **KRAFTFAHRZEUGTÜRSCHLOSSGEHÄUSE**

MOTOR VEHICLE DOOR LOCK HOUSING

BOÎTIER DE SERRURE DE PORTIÈRE DE VÉHICULE À MOTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.04.2011 DE 202011005085 U**

(43) Veröffentlichungstag der Anmeldung:
**19.02.2014 Patentblatt 2014/08**

(73) Patentinhaber: **Kiekert Aktiengesellschaft**
**42579 Heiligenhaus (DE)**

(72) Erfinder: **BLUMENTHAL, Frank**
**47906 Kempen (DE)**

(74) Vertreter: **Struck, Norbert et al**
**Gille Hrabal**
**Patentanwälte**
**Brucknerstrasse 20**
**40593 Düsseldorf (DE)**

(56) Entgegenhaltungen:
WO-A1-2010/136004    DE-A1-102009 042 630
DE-U1- 20 307 111    US-A- 5 480 309
US-A1- 2005 198 819    US-A1- 2009 296 356

**Beschreibung**

Die Erfindung betrifft ein Kraftfahrzeugtürschlossgehäuse mit wenigstens einer elektrische Leiterbahnen aufweisenden Leiterbahnplatte, mit zumindest einer nach außen weisenden Ausnehmung zur Aufnahme der elektrischen Leiterbahnen, und mit Durchgängen in der Ausnehmung zur Verbindung der Leiterbahnen mit dem Gehäuseinneren.

Solche Kraftfahrzeugtürschlossgehäuse sind in der Regel mehrteilig aufgebaut und setzen sich typischerweise aus einem metallischen Schlosskasten und einem aus Kunststoff gefertigten eigentlichen Schlossgehäuse bzw. einer Kunststoffhaube oder einem Gehäusekörper aus Kunststoff zusammen. An diesem aus Kunststoff gefertigten eigentlichen Schlossgehäuse ist die fragliche Ausnehmung ausgebildet. Diese weist nach außen hin, lässt sich also von außen her mit einer oder mehreren Leiterbahnen bestücken. Dadurch kann das Kraftfahrzeugtürschloss zusammen mit dem Kraftfahrzeugtürschlossgehäuse in seinen Grundzügen hergestellt werden und werden erst zum Abschluss die Leiterbahnen in die Ausnehmung eingelegt. Um die Leiterbahnen vor Korrosionen oder Umwelteinflüssen zu schützen, wird die Ausnehmung mit einer Vergussmasse versiegelt.

Im gattungsbildenden Stand der Technik nach der WO 2010/136004 A1 wird so vorgegangen, dass die Leiterbahnen als Leiterbahngitter bzw. Stanzgitter in der Ausnehmung platziert und mit im Gehäuseinneren vorhandenen elektrischen/elektronischen Bauteilen kontaktiert werden. Das hat sich grundsätzlich bewährt, ist allerdings im Hinblick auf den Montage- und Herstellungsaufwand verbesserungsfähig. Denn heutzutage wird oftmals mit standardisierten Bauteilen gearbeitet, die es erfordern, dass beispielsweise unterschiedliche Leiterbahnen bzw. Leiterbahngebilde in ein und derselben Aufnahme des zugehörigen Kraftfahrzeugtürschlossgehäuses aufgenommen werden sollen. Hierzu liefert der Stand der Technik bisher keine überzeugenden Lösungen.

Der Erfindung liegt das technische Problem zugrunde, ein derartiges Kraftfahrzeugtürschlossgehäuse so weiter zu entwickeln, dass ein universeller Einsatz ermöglicht wird und die Montage/Herstellung vereinfacht sind.

Zur Lösung dieser technischen Problemstellung umfasst ein gattungsgemäßes Kraftfahrzeugtürschlossgehäuse im Rahmen der Erfindung die Merkmale des Anspruchs 1.

Im Rahmen der Erfindung werden die Leiterbahnen also ausdrücklich nicht als Leiterbahngebilde respektive Stanzgitter gemäß der WO 2010/136004 A1 in der Aufnahme positioniert. Vielmehr kommt erfindungsgemäß eine die Leiterbahnen tragende Leiterbahnplatte zum Einsatz. Diese Leiterbahnplatte ist mit gehäuseseitigen Füßen ausgerüstet. Dabei hat es sich bewährt, dass die betreffenden Füße als Leiterbahnverlängerungen ausgebildet sind. Mit Hilfe der Füße bzw. der Leiterbahnverlängerungen greift die Leiterbahnplatte in jeweils einzelne Durchgänge innerhalb der Ausnehmung ein. Auf diese Weise wird die Leiterbahnplatte im Innern der Ausnehmung einerseits zentriert und sorgen die als Leiterbahnverlängerungen ausgebildeten Füße andererseits dafür, dass die von der Leiterbahnplatte getragenen Leiterbahnen die gewünschte elektrische Verbindung mit im Gehäuseinnern vorgesehenen elektrischen/elektronischen Bauteilen einnehmen können.

Zu diesem Zweck mag die Auslegung so getroffen sein, dass die Füße gehäuseseitig der Leiterbahnplatte in zugehörige Steckaufnahmen im Gehäuseinneren eingreifen. Bei diesen Steckaufnahmen kann es sich um mechanische Steckaufnahmen handeln, wenn die gehäuseseitigen Füße nicht leitend ausgelegt sind. Im Regelfall sind die gehäuseseitigen Füße jedoch als von der Leiterbahnplatte unterseitig im Wesentlichen rechtwinklig abstehende Leiterbahnverlängerungen ausgebildet. Dann handelt es sich bei den Steckaufnahmen um elektrische Steckaufnahmen, also solche, die unmittelbar für eine elektrische Kontaktierung sorgen, sobald die als Leiterbahnverlängerungen ausgelegten Füße in die fraglichen elektrischen Steckaufnahmen eingreifen. Mit den elektrischen Steckaufnahmen mögen einzelne elektrische/elektronische Bauteile im Gehäuseinnern des Kraftfahrzeugtürschlossgehäuses verbunden sein.

Typischerweise weist ein Kraftfahrzeugtürschlossgehäuse in seinem Innern ein oder mehrere Elektromotoren, einzelne Sensoren, Mikroschalter etc. auf, welche zum Betrieb des Kraftfahrzeugtürschlosses erforderlich sind, respektive einzelne Funktionsstellungen des Kraftfahrzeugtürschlosses überwachen.

Bei der Leiterbahnplatte kann es sich um generell jedwede Art von Leiterbahnplatte handeln, also um eine gedruckte Platine mit Einschicht- oder Mehrschichtaufbau, die typischerweise aus einem Isoliermaterial hergestellt wird. Die Leiterbahnen werden auf einer solchen Leiterbahnplatte durch chemische und/ oder physikalische Prozesse definiert. Außerdem mag die Leiterbahnplatte oberseitig, das heißt an einer den Gehäusefüßen an der Unterseite gegenüberliegenden Oberseite mit elektrischen/elektronischen Bauteilen bestückt sein. Hier haben sich besonders elektronische Bauteile in SMD-Bauweise (surface mounted device) als günstig erwiesen. Das ist selbstverständlich nur beispielhaft und nicht zwingend zu verstehen.

Die Leiterbahnplatte mit den gehäuseseitigen bzw. an ihrer Unterseite abstehenden Füßen wird in der Regel auf ein oder mehrere Auflager in der Ausnehmung aufgelegt. Zu diesem Zweck ist die Ausnehmung mit dem einen oder den mehreren Auflagern für die Leiterbahnplatte ausgerüstet. Bei dem oder den Auflagern handelt es sich typischerweise um einen durchgängigen Rahmen. Alternativ oder zusätzlich kann das Auflager bzw. der Rahmen auch als Dichtung ausgelegt sein.

Eine solche Ausführungsform hat sich besonders für den Fall als günstig erwiesen, dass die Leiterbahnplatte die Ausnehmung in der Art des Deckels verschließt. In diesem Fall sind der flächige Innenquerschnitt der Ausnehmung und die flächige Ausdehnung der Leiterbahnplatte typischerweise so aneinander angepasst, dass die Leiterbahnplatte in etwa formschlüssig in der Ausnehmung aufgenommen wird, auf dem einen oder den mehreren Auflagern aufliegt und hierdurch die Ausnehmung in der Art des Deckels verschließt. Dadurch kann die anschließend auf die Leiterbahnplatte aufgebrachte bzw. in die Ausnehmung eingebrachte Vergussmasse die Ausnehmung unschwer versiegeln. Dabei wird man meistens so vorgehen, dass die Vergussmasse hauptsächlich zwischen einer Oberfläche bzw. Oberseite der Leiterbahnplatte und einem kopfseitigen Rand der Ausnehmung angeordnet ist. Der Bereich von der unterseitigen Oberfläche bzw. Unterseite der Leiterbahnplatte bis hin zum Boden der Ausnehmung wird dagegen nur mit einer geringeren Schicht Vergussmasse versehen, was das Einbringen von Vergussmasse angeht. Auf diese Weise lässt sich der volumenmäßige Einsatz von Vergussmasse pro auszurüstender Ausnehmung gegenüber bisherigen Ausgestaltungen deutlich verringern. Dadurch ist die beschriebene Bauform kostenmäßig besonders günstig gestaltet.

Hinzu kommt, dass die Leiterbahnplatte inklusive der Leiterbahnen sowie der gegebenenfalls zusätzlich aufgebrachten elektrischen/elektronischen Bauteile eine vormontierte Baueinheit definiert respektive definieren kann. Im Idealfall wird also das Kraftfahrzeugtürschloss inklusive sämtlicher im Gehäuseinneren zu platzierender Hebel, Aggregate usw. komplett montiert und durch das erfindungsgemäße Kraftfahrzeugtürschlossgehäuse geschlossen. Die Ansteuerung und elektrische Verbindung der im Innern des Kraftfahrzeugtürschlossgehäuses befindlichen elektrischen/elektronischen Bauteile erfolgt nun derart, dass die Leiterbahnplatte bzw. die an dieser Stelle realisierte vormontierte Baueinheit in die Ausnehmung eingelegt wird. Dabei nutzt die an dieser Stelle realisierte Leiterbahnplatte bzw. Leiterplatte mit den darauf angebrachten Leiterbahnen sowie den gegebenenfalls elektrischen/elektronischen Bauteilen das eine oder die mehreren Auflager innerhalb der Ausnehmung zur Platzierung.

Dadurch ist sichergestellt, dass die Füße bzw. Leiterbahnverlängerungen unmittelbar die zugehörigen Durchbrüche in der Ausnehmung durchgreifen können und jenseits der Durchbrüche und im Gehäuseinneren in die dort vorgesehenen Steckaufnahmen eingreifen. Das heißt, die Platzierung der vormontierten Baueinheit respektive der Leiterplatte bzw. Leiterbahnplatte in der Ausnehmung sorgt zugleich dafür, dass die auf der Leiterbahnplatte befindlichen Leiterbahnen mit den zugehörigen und gewünschten Aggregaten im Gehäuseinnern elektrisch verbunden sind. Weitere Arbeiten sind nicht erforderlich. Sobald die vormontierte Baueinheit bzw. die Leiterbahnplatte in der Ausnehmung platziert ist, lässt sich die Ausnehmung und mit ihr die Leiterbahnplatte durch die angesprochene Vergussmasse versiegeln.

Mit anderen Worten sind keine komplizierten Montagemaßnahmen erforderlich, reicht es vielmehr aus, die vormontierte Baueinheit bzw. Leiterbahnplatte in der Ausnehmung zu platzieren, wobei dieser Vorgang zugleich für die notwendige elektrische Kontaktierung sorgt. Zum Abschluss wird die Leiterbahnplatte in der Ausnehmung versiegelt, so dass das erfindungsgemäße Kraftfahrzeugtürschlossgehäuse unmittelbar gebrauchsfertig und vorbereitet für den Einbau ist. Hierin sind die wesentlichen Vorteile zu sehen.

Nach weiterer vorteilhafter Ausgestaltung ist das Auflager für die Leiterbahnplatte bzw. die vormontierte Baueinheit an einem Rand der Ausnehmung vorgesehen. Dabei hat es sich weiter als besonders günstig erwiesen, wenn das fragliche Auflager eine Bauhöhe aufweist, welche in Verbindung mit der Bauhöhe der gegebenenfalls bestückten und aufliegenden Leiterbahnplatte einer Tiefe der Ausnehmung entspricht bzw. diese unterschreitet. Dadurch ist sichergestellt, dass die auf dem Auflager aufliegende Leiterbahnplatte bzw. deren gegebenenfalls aufgebrachte Bestückung einen kopfseitigen Rand der Ausnehmung nicht überschreitet bzw. nicht "hervorsteht". Die nach Montage der Leiterbahnplatte aufgebrachte Vergussmasse sorgt dann dafür, dass die Leiterbahnplatte vollständig oder nahezu vollständig mit der Vergussmasse abgedeckt ist bzw. keine über die Ausnehmung bzw. deren kopfseitigen Rand vorstehenden Bauteile beobachtet werden.

Von weiterer besonderer Bedeutung ist die Tatsache, dass die Durchgänge in der Ausnehmung ein an die jeweils in die Ausnehmung eingelegte Leiterbahnplatte angepasstes Lochmuster beschreiben. Mit anderen Worten, korrespondiert jede in die Ausnehmung eingelegte Leiterbahnplatte zu einem speziellen Lochmuster der Durchbrüche in der Ausnehmung. Um eine besonders standardisierte Fertigung zu erreichen und möglichst und mit ein und demselben Türschlossgehäuse bei unterschiedlich ausgelegten Türschlössern arbeiten zu können, hat es sich weiter bewährt, wenn die Ausnehmung zur Aufnahme unterschiedlicher Leiterbahnplatten eingerichtet ist. Beispielsweise ist es denkbar, dass ein und dasselbe Türschlossgehäuse eingesetzt wird, um beispielsweise ein Kraftfahrzeugtürschloss mit Zentralverriegelung und ein Kraftfahrzeugtürschloss ohne Zentralverriegelung in seinem Innern aufnehmen zu können. Beide Varianten, das heißt mit und ohne Zentralverriegelung oder mit Öffnungs-und/oder Schließhilfen, erfordern selbstverständlich unterschiedliche Leiterbahnplatten, weil beispielsweise bei der Ausführungsform mit Zentralverriegelung ein Zentralverriegelungsmotor angesteuert werden muss, die Position eines Zentralverriegelungshebels abgefragt werden muss etc.. Diese beschriebenen Funktionen entfallen naturgemäß bei einem Kraftfahrzeugtürschloss ohne Zentralverriegelungsfunktion. Als Folge hiervon verfügt die zugehörige Leiterbahnplatte für die Version mit Zentralverriegelung tendenziell über deutlich mehr gehäuseseitige Füße zur Kontaktierung der im Gehäuseinnern befindlichen Aggregate im Vergleich zu dem Fall, dass ohne Zentralverriegelung gearbeitet wird.

Um dennoch beide Varianten im Beispielfall in ein und derselben Ausnehmung bzw. ein und demselben Kraftfahrzeugtürschlossgehäuse aufnehmen zu können, korrespondieren sämtliche Leiterbahnplatten-Lochmuster zu einem Universal-Lochmuster der Durchgänge in der Ausnehmung. Das heißt, jede in der Ausnehmung platzierbare Leiterbahnplatte definiert ein eigenes Leiterbahnplatten-Lochmuster bzw. ein hierzu gehöriges Muster der gehäuseseitigen Füße an der Leiterbahnplatte. Sämtliche in der Ausnehmung platzierbare Leiterbahnplatten und die zugehörigen Leiterbahnplatten-Lochmuster definieren nun ein Universal-Lochmuster, welches typischerweise in der Ausnehmung realisiert wird.

Dieses Universal-Lochmuster ist erfindungsgemäß dadurch gekennzeichnet, dass nicht durch sämtliche Durchbrüche bzw. Durchgänge hindurch gehäuseseitige Füße der in die Ausnehmung eingelegten Leiterbahnplatte hindurchgreifen. Sondern es bleiben mehr oder minder viele Durchbrüche bei diesem Vorgang unabgedeckt.

Auf diese Weise wird nochmals die Herstellung und Montage vereinfacht. Denn unterschiedliche Bauformen des Kraftfahrzeugtürschlosses können in ein und demselben Kraftfahrzeugtürschlossgehäuse aufgenommen werden. Das gilt auch für zu dem jeweiligen Kraftfahrzeugtürschloss gehörige Leiterbahnplatten. Denn die nach außen hin weisende und die Leiterbahnplatte aufnehmende Ausnehmung ist universell zur Aufnahme der jeweils zugehörigen Leiterbahnplatte eingerichtet. Auf diese Weise ist die Lagehaltung vereinfacht und auch der Zusammenbau deutlich problemloser als bisher gestaltet. Zugleich werden Ressourcen geschont, weil die Menge an notwendiger Vergussmasse im Vergleich zum bisherigen Stand der Technik deutlich reduziert ist.

Im Folgenden wird die Erfindung anhand einer lediglich ein Ausführungsbeispiel darstellenden Zeichnung näher erläutert; es zeigen:

**Fig. 1**      das erfindungsgemäße Kraftfahrzeugtürschlossgehäuse in einer schematischen Übersicht und

**Fig. 2**      einen Querschnitt durch den Gegenstand nach Fig. 1.

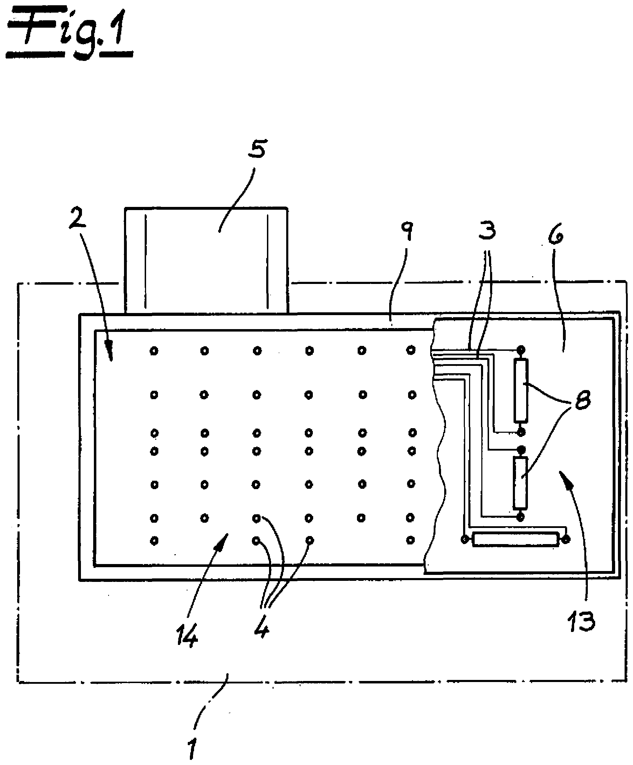

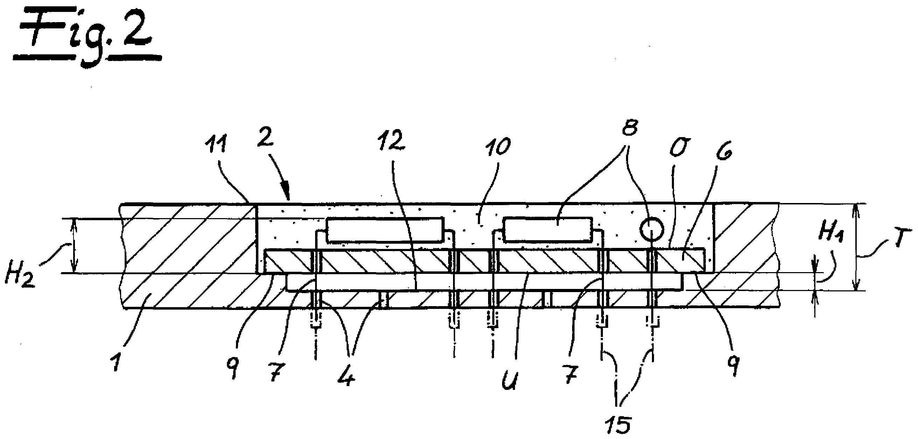

In der Fig. 1 ist ein Kraftfahrzeugtürschlossgehäuse dargestellt, welches zunächst einmal über einen aus Kunststoff gefertigten Gehäusekörper 1 verfügt. Neben diesem Gehäusekörper 1 aus Kunststoff ist typischerweise ein metallischer Schlosskasten realisiert. Dieser ist jedoch nicht dargestellt. Der metallische Schlosskasten und der Gehäusekörper 1 aus Kunststoff bilden zusammengenommen das Kraftfahrzeugtürschlossgehäuse. Von besonderer Bedeutung für die nachfolgenden Betrachtungen ist eine nach außen weisende Ausnehmung 2 an diesem Kraftfahrzeugtürschlossgehäuse. Die Ausnehmung 2 dient zur Aufnahme elektrischer Leiterbahnen 3. Außerdem sind Durchgänge 4 in der Ausnehmung 2 vorgesehen. Mit Hilfe der Durchgänge 4 in der Ausnehmung 2 werden die Leiterbahnen 3 mit dem Gehäuseinneren verbunden. Das ist schematisch in der Schnittdarstellung nach Fig. 2 dargestellt. Im Gehäuseinnern finden sich Motoren, Sensoren, Schalter, Steckkontakte etc., die über die Leiterbahnen 3 kontaktiert werden. Zu diesem Zweck stellen die Leiterbahnen 3 eine elektrische Verbindung zu einer Buchse 5 im Beispielfall her. An die Buchse 5 mag ein nicht gezeigter Stecker angeschlossen werden, welcher seinerseits die elektrische Verbindung des gezeigten Kraftfahrzeugtürschlosses mit beispielsweise einer Steuereinheit im Innern eines Kraftfahrzeuges sicherstellt.

Im Rahmen der Darstellung und nach der Erfindung werden die Leiterbahnen 3 zusammen mit einer die Leiterbahnen 3 tragenden Leiterbahnplatte 6 in der Aufnahme bzw. der Ausnehmung 2 platziert. Das heißt, die Leiterbahnen 3 sind an der Leiterbahnplatte 6 ausgebildet, beispielsweise als aufgedruckte oder auf andere prozesstechnische Art und Weise auf die Leiterbahnplatte 6 aufgebrachte elektrisch leitfähige Bahnen. Außerdem sind gehäuseseitige Füße 7 an der Leiterbahnplatte 6 vorgesehen, die eine elektrische Verbindung mit den einzelnen Leiterbahnen 3 eingehen. Die gehäuseseitigen Füße 7 stehen in etwa senkrecht von einer Unterseite U der Leiterbahnplatte 6 ab, wie die Schnittdarstellung nach Fig. 2 deutlich macht. Auf einer Oberseite O der Leiterbahnplatte 6 mögen elektrische/elektronische Bauteile 8 angeordnet sein. Hier hat sich die sogenannte SMD-Technik als besonders günstig erwiesen.

Auf diese Weise kann die Leiterbahnplatte 6 inklusive der elektrischen/elektronischen Bauteile 8 sowie der gehäuseseitigen Füße 7 zusammenfassend als vormontierte Baueinheit 6, 7, 8 hergestellt werden. Diese vormontierte Baueinheit 6, 7, 8 lässt sich in der Ausnehmung 2 platzieren. Zu diesem Zweck ist die Ausnehmung 2 mit ein oder mehreren Auflagern 9 ausgerüstet, die man ebenfalls am besten in der Schnittdarstellung nach Fig. 2 erkennt. Tatsächlich handelt es sich bei dem Auflager 9 im Ausführungsbeispiel um einen Rahmen 9, der an einem Rand der Ausnehmung 2 vorgesehen ist.

Zu diesem Zweck verfügt das Auflager 9 ausweislich der Fig. 2 über eine Bauhöhe $H_1$, welche in Verbindung mit einer Bauhöhe $H_2$ der bestückten und auf dem Auflager 9 aufliegenden Leiterbahnplatte 6 respektive der Bauhöhe $H_2$ der Baueinheit 6, 7, 8 einer Tiefe T der Ausnehmung 2 entspricht bzw. diese unterschreitet. Es gilt also erfindungsgemäß folgende Relation:

$$H1 + H2 \leq T.$$

Da darüber hinaus die Leitebahnplatte 6 von ihrer flächenmäßigen Ausdehnung her an die flächenmäßige Ausdehnung der Ausnehmung 2 angepasst ist bzw. die Leiterbahnplatte 6 überwiegend formschlüssig in die Ausnehmung 2 eingreift, erklärt sich, dass die Leiterbahnplatte 6 die Ausnehmung 2 wie ein Deckel verschließt, sobald sie auf dem oder den Auflagern 9 ruht. Tatsächlich wird auf diese Weise sichergestellt, dass sich Vergussmasse 10 hauptsächlich zwischen der Oberfläche bzw. Oberseite O der Leiterbahnplatte 6 und einem kopfseitigen Rand 11 der Ausnehmung 2 findet. Dagegen ist ein Bereich zwischen der Unterseite U der Leiterbahnplatte 6 und einem Boden 12 der Ausnehmung 2 nur mit einer geringen Schicht Vergussmasse 10 versehen.

Die Ausnehmung 2 ist am Gehäusekörper 1 aus Kunststoff ausgebildet, typischerweise einstückig mit dem Gehäusekörper 1 aus Kunststoff ausgelegt und an diesen angeformt. Vergleichbares gilt für die Auflager 9 bzw. den Rand 9. Die Ausnehmung 2 respektive der Gehäusekörper 1 aus Kunststoff werden nun durchweg beibehalten, und zwar auch dann, wenn im Gehäuseinnern unterschiedliche Ausführungsformen des jeweils realisierten Türschlosses platziert werden. Beispielsweise ist es denkbar, dass ein und dasselbe Kraftfahrzeugtürschlossgehäuse einerseits ein Kraftfahrzeugtürschloss mit Zentralverriegelung und andererseits ein Kraftfahrzeugtürschloss ohne Zentralverriegelung im Gehäuseinnern beherbergt und aufnimmt.

Da darüber hinaus die Durchbrüche bzw. Durchgänge 4 in der Ausnehmung 2 ein an die jeweils in die Ausnehmung 2 eingelegte Leiterbahnplatte 6 angepasstes Lochmuster 13 beschreiben, wird deutlich, dass je nach Aufrüstungsgrad des Türschlosses (mit und ohne Zentralverriegelung) auch unterschiedliche vormontierte Baueinheiten (6, 7, 8) zum Einsatz kommen. Diese unterschiedlichen vormontierten Baueinheiten 6, 7, 8 korrespondieren zu jeweils angepassten und variierenden Lochmustern 13. Das heißt, die Ausnehmung 2 ist zur Aufnahme unterschiedlicher Leiterbahnplatten 6 respektive variierender vormontierter Baueinheiten 6, 7, 8 eingerichtet.

Die einzelnen korrespondierenden Lochmuster 13 gehören nun zu der zugehörigen vormontierten Baueinheit 6, 7, 8 bzw. der zugehörigen Leiterbahnplatte 6. Daraus resultiert ein Leiterbahnplatten-Lochmuster 13, welches letztlich von der Anordnung der gehäuseseitigen Füße 7 vorgegeben wird, die durch die zugehörigen Durchgänge 4 hindurchgreifen (müssen).

Sämtliche unterschiedlichen Leiterbahnplatten-Lochmuster 13 definieren nun ein Universal-Lochmuster 14 der Durchgänge 4 in der Ausnehmung 2. Dieses Universal-Lochmuster 14 ist so ausgelegt und gestaltet, dass jede denkbare Variante des im Innern des erfindungsgemäßen Kraftfahrzeugtürschlossgehäuses aufgenommenen Kraftfahrzeugtürschlosses aufgenommen werden kann, wobei zu der jeweiligen Variante eine eigene vormontierte Baueinheit 6, 7, 8 gehört. Diese Ausgestaltung ist möglich, weil die Ausnehmung 2 von der Leiterbahnplatte 6 respektive der vormontierten Baueinheit 6, 7, 8 in der Art eines Deckels verschlossen wird und sich die Vergussmasse 10 praktisch vorrangig zwischen der Oberfläche bzw. Oberseite O der Leiterbahnplatte 6 und dem kopfseitigen Rand 11 der Ausnehmung 2 befindet. Ein Eindringen von Vergussmasse 10 in unbelegte Durchgänge 4 und somit ins Gehäuseinnere kann praktisch ausgeschlossen werden.

Sobald die vormontierte Baueinheit 6, 7, 8 bzw. die Leiterbahnplatte 6 in der Ausnehmung 2 auf dem Rahmen 9 platziert ist, greifen die gehäuseseitigen Füße 7 in Steckaufnahmen 15 im Gehäuseinnern ein. Bei diesem Vorgang durchgreifen die gehäuseseitigen Füße 7 einzelne Durchgänge 4 in der Ausnehmung 2. Die Steckaufnahmen 15 sind im Ausführungsbeispiel als elektrische Steckaufnahmen 15 ausgelegt und stehen über Leitungen mit den im Gehäuseinnern vorgesehenen Aggregaten in Verbindung. Auf diese Weise stellt die im Innern der Ausnehmung 2 platzierte Baueinheit 6, 7, 8 unmittelbar die notwendige elektrische Verbindung von der Buchse 5 über die Leiterbahnen 3 bis hin zu den anzusteuernden oder abzufragenden Aggregaten im Gehäuseinnern her.

**Patentansprüche**

1. Kraftfahrzeugtürschlossgehäuse mit wenigstens einer elektrische Leiterbahnen (3) aufweisenden Leiterbahnplatte (6), mit zumindest einer nach außen weisenden Ausnehmung (2) zur Aufnahme der elektrischen Leiterbahnen (3), und mit Durchgängen (4) in der Ausnehmung (2) zur Verbindung der Leiterbahnen (3) mit dem Gehäuseinneren, wobei die Leiterbahnen (3) zusammen mit wenigstens der sie tragenden Leiterbahnplatte (6) in der Ausnehmung (2) platziert sind, wobei die Leiterbahnplatte (6) mit gehäuseseitigen Füßen (7) ausgerüstet ist und die gehäuseseitigen Füße (7) als Leiterbahnenverlängerung (7) ausgebildet sind und jeweils einzelne Durchgänge (4) durchgreifen, wobei nicht durch sämtliche Durchgänge (4) hindurch gehäuseseitige Füße (7) hindurchgreifen.

2. Kraftfahrzeugtürschlossgehäuse nach Anspruch 1, **dadurch gekennzeichnet, dass** die gehäuseseitigen Füße (7) in Steckaufnahmen (15) im Gehäuseinnern eingreifen.

3. Kraftfahrzeugtürschlossgehäuse nach einem der Ansprüche 1 bis 2, **dadurch gekennzeichnet, dass** die Ausnehmung (2) mit einem oder mehreren Auflagern (9) für die Leiterbahnplatte (6) ausgerüstet ist.

4. Kraftfahrzeugtürschlossgehäuse nach Anspruch 3, **dadurch gekennzeichnet, dass** das bzw. die Auflager (9) als durchgängiger Rahmen (9) ausgebildet sind und an einem Rand der Ausnehmung (2) vorgesehen sind.

**5.** Kraftfahrzeugtürschlossgehäuse nach einem der Ansprüche 3 bis 4, **dadurch gekennzeichnet, dass** das Auflager (9) eine Bauhöhe (H1) aufweist, welche in Verbindung mit einer Bauhöhe (H2) der gegebenenfalls bestückten und aufliegenden Leiterbahnplatte (6) einer Tiefe (T) der Ausnehmung (2) entspricht bzw. diese unterschreitet.

**6.** Kraftfahrzeugtürschlossgehäuse nach einem der Ansprüche 1 bis 5, **dadurch gekennzeichnet, dass** die Leiterbahnplatte (6) inklusive der Leiterbahnen (3) sowie gegebenenfalls elektrischer/elektronischer Bauteile (8) eine vormontierte Baueinheit (6, 7, 8) definiert.

**7.** Kraftfahrzeugtürschlossgehäuse nach einem der Ansprüche 1 bis 6, **dadurch gekennzeichnet, dass** die Durchgänge (4) in der Ausnehmung (2) ein an die jeweils in die Ausnehmung (2) eingelegte Leiterbahnplatte (6) angepasstes Lochmuster (13) beschreiben.

**8.** Kraftfahrzeugtürschlossgehäuse nach einem der Ansprüche 1 bis 7, **dadurch gekennzeichnet, dass** die Ausnehmung (2) zusammen mit der eingelegten Leiterbahnplatte (6) mittels einer Vergussmasse (10) versiegelt wird.

**9.** Kraftfahrzeugtürschlossgehäuse nach einem der Ansprüche 1 bis 8, **dadurch gekennzeichnet, dass** die Leiterbahnplatte (6) die Ausnehmung (2) in der Art eines Deckels verschließt.

**Claims**

**1.** Vehicle door lock housing with at least one conductor path board (6) that comprises electric conductor paths (3), with at least one outwards pointing hollow (2) for receiving the electric conductor paths (3), and with passageways (4) in the hollow (2) for connecting the conductor paths (3) with the inside of the housing, wherein the conductor paths (3) together with at least the conductor path board (6) carrying it are placed in the hollow (2), wherein the conductor path board (6) is equipped with feet (7) at the side of the housing and the feet (7) at the side of the housing are formed as conductor paths extensions (7) and reach through respective single passageways (4), wherein feet (7) at the side of the housing do not reach though all passageways (4).

**2.** Vehicle door lock housing according to claim 1, **characterized in that** the feet (7) at the side of the housing reach in plugging receptacles (15) in the inside of the housing.

**3.** Vehicle door lock housing according to one of the claims 1 or 2, **characterized in that** the hollow (2) is equipped with one or several supports (9) for the conductor path board (6).

**4.** Vehicle door lock housing according to claim 3, **characterized in that** the support (9) respectively the supports (9) are formed as continuous frame (9) and provided at a border of the hollow (2).

**5.** Vehicle door lock housing according to one of the claims 3 or 4, **characterized in that** the support (9) has a height of construction (H1), which corresponds together with a height of construction (H2) of the where necessary fitted and supported conductor path board (6) to a depth (T) of the hollow (2) respectively fall below of it.

**6.** Vehicle door lock housing according to one of the claims 1 to 5, **characterized in that** the conductor path board (6) including the conductor paths (3) as well as where necessary electric/electronic components (8) define a pre-assembly unit (6, 7, 8).

**7.** Vehicle door lock housing according to one of the claims 1 to 6, **characterized in that** the passageways (4) in the hollow (2) specify a hole pattern (13) being adapted to the respective conductor path board (6) that is inserted in the hollow (2).

**8.** Vehicle door lock housing according to one of the claims 1 to 7, **characterized in that** the hollow (2) is sealed together with the inserted conductor path board (6) by means of a casting compound (10).

**9.** Vehicle door lock housing according to one of the claims 1 to 8, **characterized in that** the conductor path board (6) closes the hollow (2) in the way of a lid.

**Revendications**

**1.** Boîtier de serrure de portière de véhicule à moteur comprenant au moins une plaque à circuits imprimés (6) comprenant des pistes conductrices (3), comprenant aussi au moins un évidement (2) dirigé vers l'extérieur pour recevoir les pistes conductrices (3) et comprenant des passages (4) dans l'évidement (2) pour relier les pistes conductrices (3) à l'intérieur de boîtier, les pistes conductrices (3) étant disposées ensemble avec au moins la plaque à circuits imprimés (6) qui les porte dans l'évidement (2), la plaque à circuits imprimés (6) étant équipée de pieds (7) sur le côté du boîtier et les pieds (7) sur le côté du boîtier étant conçus comme des prolongements de pistes conductrices (7) et traversant chacun des passages individuels (4), les pieds (7) sur le côté du boîtier ne traversant pas tous les passages (4).

**2.** Boîtier de serrure de portière de véhicule à moteur selon la revendication 1, **caractérisé en ce que** les pieds (7) sur le côté du boîtier viennent en prise avec des logements d'enfichage (15) dans l'intérieur de boîtier.

**3.** Boîtier de serrure de portière de véhicule à moteur selon l'une des revendications 1 à 2, **caractérisé en ce que** l'évidement (2) est muni d'un ou de plusieurs supports (9) pour la plaque à circuits imprimés (6).

**4.** Boîtier de serrure de portière de véhicule à moteur selon la revendication 3, **caractérisé en ce que** le ou les support(s) (9) est/sont conçu(s) comme un cadre continu (9) et est/sont prévu(s) sur un bord de l'évidement (2).

**5.** Boîtier de serrure de portière de véhicule à moteur selon l'une des revendications 3 à 4, **caractérisé en ce que** le support (9) comprend une hauteur de construction (H1), qui correspond, en combinaison avec une hauteur de construction (H2) de la plaque à circuits imprimés (6) éventuellement équipée et reposant sur le support, à une profondeur (T) de l'évidement (2) ou reste inférieure à celle-ci.

**6.** Boîtier de serrure de portière de véhicule à moteur selon l'une des revendications 1 à 5, **caractérisé en ce que** la plaque à circuits imprimés (6), les pistes conductrices (3) et éventuellement des composants électriques/électroniques (8) y compris, définit une unité modulaire préassemblée.

**7.** Boîtier de serrure de portière de véhicule à moteur selon l'une des revendications 1 à 6, **caractérisé en ce que** les passages (4) dans l'évidement (2) décrivent une matrice de trous (13) adaptée à la plaque à circuits imprimés (6) respectivement insérée dans l'évidement (2).

**8.** Boîtier de serrure de portière de véhicule à moteur selon l'une des revendications 1 à 7, **caractérisé en ce que** l'évidement (2) est scellé ensemble avec la plaque à circuits imprimés (6) insérée par moyen d'une masse de scellement (10).

**9.** Boîtier de serrure de portière de véhicule à moteur selon l'une des revendications 1 à 8, **caractérisé en ce que** la plaque à circuits imprimés (6) ferme l'évidement (2) à la manière d'un couvercle.

# Fig.1

**Fig.2**

EP 2 697 461 B1

**EP 2 697 461 B1**

**IN DER BESCHREIBUNG AUFGEFÜHRTE DOKUMENTE**

**In der Beschreibung aufgeführte Patentdokumente**

- WO 2010136004 A1